# EUROPEAN PATENT APPLICATION

(11) **EP 1 331 454 A1**
(43) Date of publication of application: **30.07.2003**
(21) Application number: 01976843.1
(22) Date of filing: 26.10.2001
(51) Int. Cl.: F24F 7/06

(54) **PULLING ROOM**

(30) Priority: 31.10.2000 JP 2000333507
(71) Applicant: Shin-Etsu Handotai Co., Ltd, Tokyo 100-0005 (JP)
(72) Inventor: ODA, Michiaki, Shin-Etsu Handotai Co.Ltd.,, Takefu-shi, Fukui 915-8525 (JP); NAKAGAWA, Kazuya, Shin-Etsu Handotai Co.Ltd., Takefu-shi, Fukui 915-8525 (JP); MATSUSHIMA, Hideaki, Shin-Etsu Handotai Co.Ltd., Nishishirakawa-gun, Fukushima 961-8061 (JP); SEKI, Hidetoshi, Shin-Etsu Handotai Co.Ltd., Nishishirakawa-gun, Fukushima 961-8061 (JP); HAYASHI, Toshiro, Shin-Etsu Handotai Co.Ltd., Chiyoda-ku, Tokyo 100-0005 (JP)
(74) Representative: Cooper, John
(86) International application number: JP0109436
(87) International publication number: WO02037034

(57) **Abstract**

A cleaned pulling room installed with a plurality of single crystal pulling apparatuses, having a plurality of operation floors and supplied with clean air as a down flow from a ceiling or an upper position neighboring the ceiling, wherein at least three operation floors are provided depending on degrees of cleanness required for operations performed on each of the floors. Thus, there is provided a pulling room that can separate dusting operations such as operations of dismantlement and cleaning of the furnace body and structural members in the furnace body and operations requiring highly clean environment such as charging of raw material into the furnace body as preparation for starting running of the pulling apparatuses, and can secure safety of the operations even when the pulling apparatuses become larger.

## Description

### Technical Field

The present invention relates to a floor structure of a pulling room in which single crystal pulling apparatuses are installed.

### Background Art

Conventionally, several to several tens of pulling apparatuses for semiconductor single crystals such as those of silicon used as semiconductor substrate materials are installed in one pulling room, and the pulling room in which the apparatuses are installed is divided into two stories including an upper story which requires high cleanness and a lower story in which the pulling apparatus bodies, utility facilities for running the apparatuses and so forth are installed, and has a structure where clean air is always supplied and flown downwardly from a ceiling of the pulling room or a position in the vicinity of it.

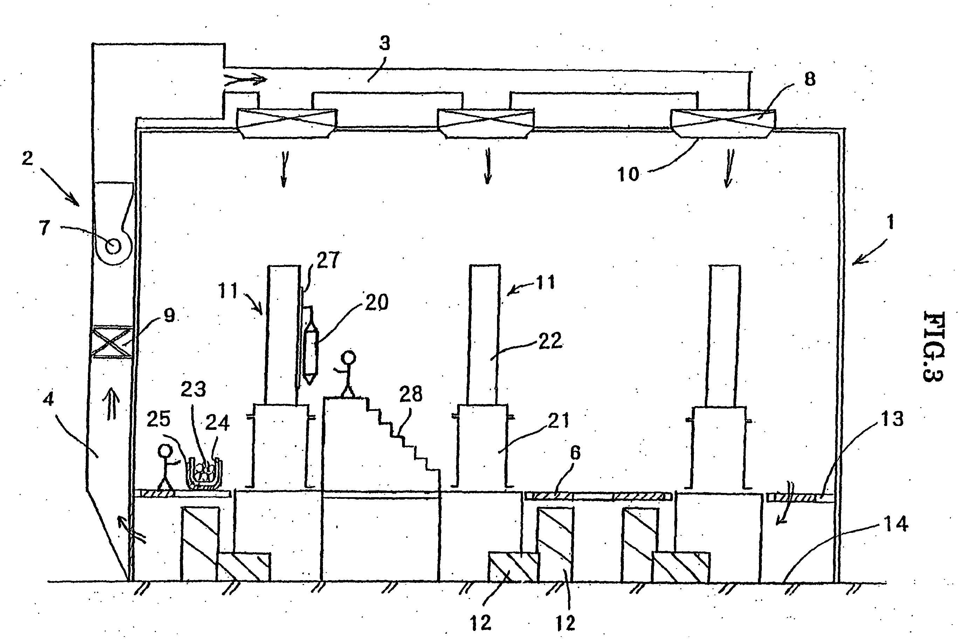

For example, the pulling room shown in Fig. 3 is one having two-story operation floor. In the pulling room 1, several to several tens of pulling apparatuses 11 for pulling single crystals (those based on the Czochralski method) are installed, and it is divided into two stories of the upper story and the lower story by an upper operation floor 13 having ventilation holes 6. Further, there is provided a circulation type air conditioning system 2, in which clean air is blown off from a blow-off outlets 10 of filters 8 disposed near the ceiling of the upper story and contaminated flow is evacuated from a return duct 4 disposed on a side wall of the lower story or the like through the ventilation holes 6, thermally controlled by a heat exchanger 9, and sent out to a ventilation duct 3 by a ventilation fan 7.

Furthermore, on the lower operation floor 14, there are provided, besides the bodies of the pulling apparatuses 11, accessory apparatuses for operating the pulling apparatuses (electric power units, vacuum pumps, control panels, oil pressure apparatuses etc.), utility facilities 12 including piping for circulating cooling water, piping for waste gas, power cables and so forth. Although extraordinarily clean environment is not required for this pulling room, certain means are required in order to maintain the clean environment of the upper story.

In the pulling room 1, various operations are commonly conducted on the upper operation floor 13, which include taking out of a single crystal ingot 20 after the production through a door 27 for taking out a single crystal ingot of the pulling apparatus 11 by using a step 28, unloading operation for subsequent steps, dismantlement and cleaning of a furnace body and structural members in the furnace body, such as a main chamber 21, pulling chamber 22, graphite crucible 25, graphite heater and heat insulating material, loading of raw material and so forth, which are performed for subsequent production of single crystals. On the upper operation floor 13, in particular, it is indispensable to supply clean air to maintain high degree of cleanness, because there are used raw material polycrystal silicon 23, quartz crucible 24 and so forth, which hate dusts.

In order to improve the internal environment of such a pulling room, various attempts have been made as described below.

First, in order to prevent influence of dusting upon dismantlement and cleaning of pulling apparatus on an adjacent pulling apparatus, the applicant of the present application proposed a system in which a blowing off nozzle for clean air is provided at a position above a pulling apparatus and a suction fan is provided in or below a base disposed below the pulling apparatus body to prevent diffusion of down flow (refer to Japanese Patent Laid-open (Kokai) Publication No. 6-159751).

Further, the applicant of the present application also proposed a pulling apparatus provided with a local operation deck, local ladder or the like in order to improve workability and secure safety, because conventional two-story floor structure became unable to meet requirements arisen in connection with use of a larger pulling apparatus used for single crystals of a larger diameter (refer to Japanese Patent Application No. 11-113335).

Furthermore, there was proposed a system in which pulling apparatuses are disposed one by one in compartmentalized rooms in order to prevent the influence of dusting on surroundings, and clean air is supplied from an upper story to a lower story so that desired degree of cleanness should be obtained for each story floor provided therein (refer to US Patent No. 5,641,354). Although a three-story floor structure was disclosed in this invention, the pulling apparatuses are disposed one by one in compartmentalized rooms and the floor is compartmentalized, and therefore filters, ducts and so forth for air conditioning are required for each room. Accordingly, the installation area per pulling apparatus becomes larger and the construction cost increases. Further, an automatic transportation apparatus is required as a measure for use of heavier weight, but introduction of such an automatic transportation apparatus into such a room is troublesome. Moreover, it also suffers from other problems, for example, when a pulling apparatus must be replaced, the limitation concerning layout imposed by the compartmentalized cell structure makes it impossible to replace it with a larger apparatus. In addition, it also suffers from disadvantages, for example, when on-site monitoring is performed, the monitoring must be performed for every rooms because of the compartmentalized structure, and thus it is impossible to quickly perform maintenance operations or cope with an emergent situation such as at the time of electric power failure.

Semiconductor devices have rapidly become finer and hence higher quality of single crystals has come to be required, and this technical tide tends to be further accelerated in connection with use of a larger diameter of the crystals. Under such a situation, if dusting operations such as dismantlement and cleaning of the furnace body and structural members in the furnace body and operation requiring highly clean environment such as charging of raw material into the furnace body as preparation for starting running of the pulling apparatus are performed on the same operation floor as conventional techniques, dusting substances may contaminate the charged raw materials and may cause degradation of single crystal ingot quality or adversely affect the workability. In particular, in a pulling room in which a plurality of pulling apparatuses are installed, the cleaning operation and raw material charging operation of adjacent pulling apparatuses may be simultaneously performed on the same operation floor, and the problems become more serious.

Further, in order to solve the aforementioned problems, it has been also aimed at to reduce construction cost and maintenance cost by using a smaller installation area per pulling apparatus and using minimum facilities including filters and ducts for air conditioning. Moreover, there are also desired ameliorations of the limitations concerning layout in cases of introducing an automatic transportation apparatus as a measure for use of heavy weight or replacement of pulling apparatus, in particular, in a case of replacement with a larger pulling apparatus, easier on-site monitoring, and quicker maintenance and quicker emergent operation such as at the time of electric power failure.

Furthermore, use of a larger pulling apparatus has advanced in such a degree that height of apparatus should exceed 10 m, and difference between the height for the operation of taking out a single crystal after the production and the height for the operation of dismantlement and cleaning of the furnace body and structural members in the furnace body tends to become larger, and methods for securing degree of cleanness of operation environment correspond to each operation and securing safety have been studied.

### Disclosure of the Invention

Therefore, the present invention has been accomplished in view of such conventional problems, and its main object is to provide a pulling room in which a plurality of pulling apparatuses are installed, which can separate dusting operations such as operations of dismantlement and cleaning of the furnace body and structural members in the furnace body and operations requiring highly clean environment such as charging of raw material into the furnace body as preparation for starting running of the pulling apparatuses, and can secure safety of the operations even when the pulling apparatuses become larger.

In order to achieve the aforementioned object, the pulling room of the present invention is a cleaned pulling room installed with a plurality of single crystal pulling apparatuses, having a plurality of operation floors and supplied with clean air as a down flow from a ceiling or an upper position neighboring the ceiling, wherein at least three operation floors are provided depending on degrees of cleanness required for operations performed on each of the floors.

In such a pulling room, clean air is supplied as a down flow from the ceiling with degree of cleanness according to degree of cleanness required at each of, for example, at least three operation floors of the pulling room including an uppermost floor, intermediate floor and lowermost floor. Thus, an operation requiring the highest degree of cleanness can be performed on the uppermost floor, an operation for which slightly lower degree of cleanness is sufficient can be performed on the intermediate floor, and an operation that does not require degree of cleanness so much can be performed on the lowermost floor. Therefore, single crystal pulling operations requiring different degrees of cleanness depending on types of the operations can be separately performed on each of the floors.

By using such a configuration as described above, the installation area per pulling apparatus can be made smaller, and maintenance becomes easier since facilities such as filters and ducts for air conditioning can be simplified. Therefore, the construction cost and the maintenance cost for facilities can be reduced. In particular, when an automatic transportation apparatus is introduced as a measure for use of heavier weight, there is required a passage where the automatic transportation apparatus is passed. However, since the room is not compartmentalized as rooms on each floor, it can be introduced extremely easily. Furthermore, there are also obtained advantages that, when on-site monitoring is performed, it can be performed easily also because the room is not compartmentalized as rooms, and an emergent situation such as at the time of electric power failure can be coped with quickly. Moreover, since the room is not compartmentalized as rooms, it suffers from less limitation concerning layout, and pulling apparatuses can be easily replaced. In particular, if the height of the ceiling is designed to be sufficiently high for introduction of a large pulling apparatus, so much difficulty is not caused.

In the present invention, the floor structure of the pulling room may comprise at least an operation floor for loading of raw material and unloading of single crystals that require high degree of cleanness, which is provided in an uppermost story, an operation floor of low degree of cleanness for cleaning of inside of pulling apparatuses accompanied by dusting after production of single crystals and assembling of furnace body structural members, which is provided in an intermediate story, and an operation floor on which pulling apparatus bodies, incidental facilities thereof and utility facilities not requiring cleanness are installed and maintenance operations therefor are performed, which is provided in a lowermost story.

At least three floors can be used as the floors of the pulling room as described above, in which the uppermost floor can be used as an operation floor on which loading of raw materials such as polycrystal and quartz crucible and unloading of single crystal ingots after the production that require the highest degree of cleanness are performed, the intermediated floor can be used as an operation floor on which cleaning of inside of pulling apparatuses accompanied by dusting and assembling of furnace body constituting internal members (graphite members) for subsequent operation, which requires a certain degree of cleanness, are performed, and the lowermost floor can be used as an operation floor not requiring particular cleanness on which pulling apparatus bodies, incidental facilities thereof and utility facilities are installed and maintenance operations therefor are performed. By using the above structure, even when a plurality of pulling apparatuses are installed, the raw material charging operation and the dusting operations can always be separated, and thus generation of crystal growth failure or quality degradation of crystal due to contamination of the raw material and so forth with dusts can be prevented. Further, since the unloading operation of grown single crystal ingots can be performed on the uppermost floor, it becomes unnecessary to carry out operations at a high position by using a ladder or the like, and thus safety can be secured.

According to the present invention, even in a pulling room installed with a plurality of pulling apparatuses, clean air blown off from the ceiling direction as a down flow is not contaminated with dusting substances in the room, thus it becomes possible to perform operations on each of the stratified floors with a desired degree of cleanness and thereby generation of crystal growth failure or quality degradation of crystal due to contamination with dusting substances can be prevented. In particular, this structure can cancel the contradiction of the conventional technique that the loading of raw material and the cleaning operation of inside of the furnace body are performed on a floor of the same degree of cleanness.

Further, while the difference between the height for the operation of taking out a single crystal ingot after the production and the height for the operation of cleaning of inside of the furnace body has become larger due to use of a larger pulling apparatus, operations at a high position using a step or the like are made unnecessary by the use of three or more floors, and thus there is also obtained an advantage that safety is secured.

### Brief Explanation of the Drawings

Fig. 1 is a schematic view showing an exemplary pulling room of the present invention.

Fig. 2 is a perspective view showing an exemplary pulling room of the present invention.

Fig. 3 is a schematic view showing a conventional pulling room.

### Best Mode for Carrying out the Invention

Embodiments of the present invention will be explained hereafter. However, the present invention is not limited to these.

The inventors of the present invention found that, if, in a cleaned pulling room installed with a plurality of crystal pulling apparatuses and having a plurality of operation floors, wherein clean air is supplied as a down flow from a ceiling or at an upper position near the ceiling, operations performed on the floors could be separated depending on degree of cleanness required for each operation, high degree of cleanness could be maintained in the room and the pulling apparatuses, thus generation of crystal growth failure or quality degradation of crystal due to contamination with dusting substances can be prevented and operations at a high position using a ladder or the like required in connection with use of a larger pulling apparatus can be eliminated. They further defined various conditions therefor and thus accomplished the present invention.

As described above, the pulling room of the present invention is a pulling room installed with a plurality of crystal pulling apparatuses, having a plurality of operation floors, and supplied with clean air as a down flow from a ceiling or at an upper position near the ceiling, and it is constituted by providing three or more of operation floors according to degree of cleanness required for operations performed on each of the operation floors.

Further, the floor structure may be specifically constituted by an operation floor for loading of raw material and unloading of single crystal ingots that require high degree of cleanness, which is provided in an uppermost story, an operation floor of low degree of cleanness for cleaning of inside of pulling apparatuses accompanied by dusting after production of single crystals and assembling of furnace body constituting members, which is provided in an intermediate story, and an operation floor on which pulling apparatus bodies, incidental facilities thereof and utility facilities not requiring cleanness so much are installed and maintenance operations therefor are performed, which is provided in a lowermost story.

Hereafter, the functions of the pulling room of the present invention will be explained by referring the appended drawings.

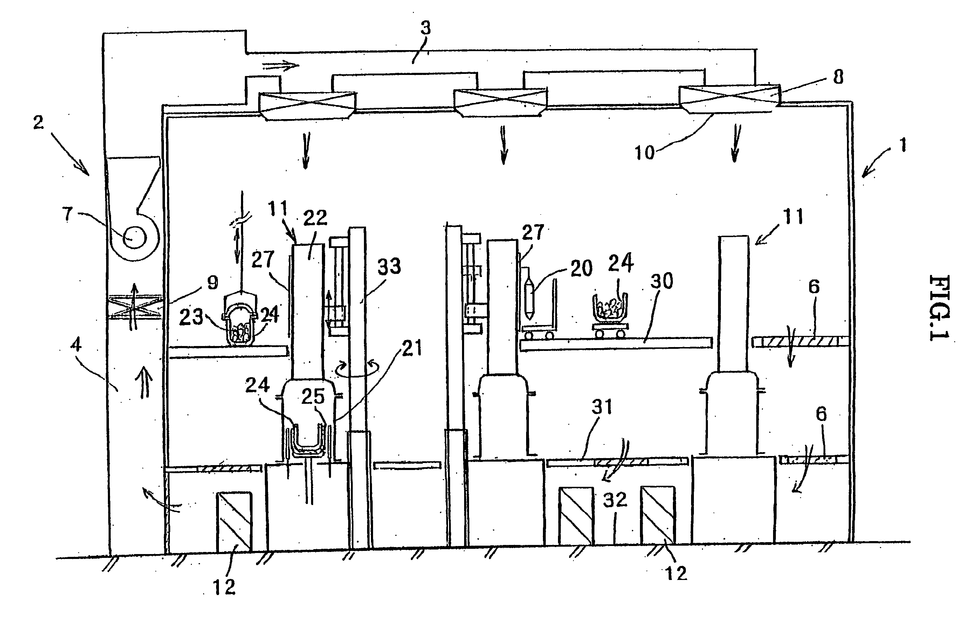

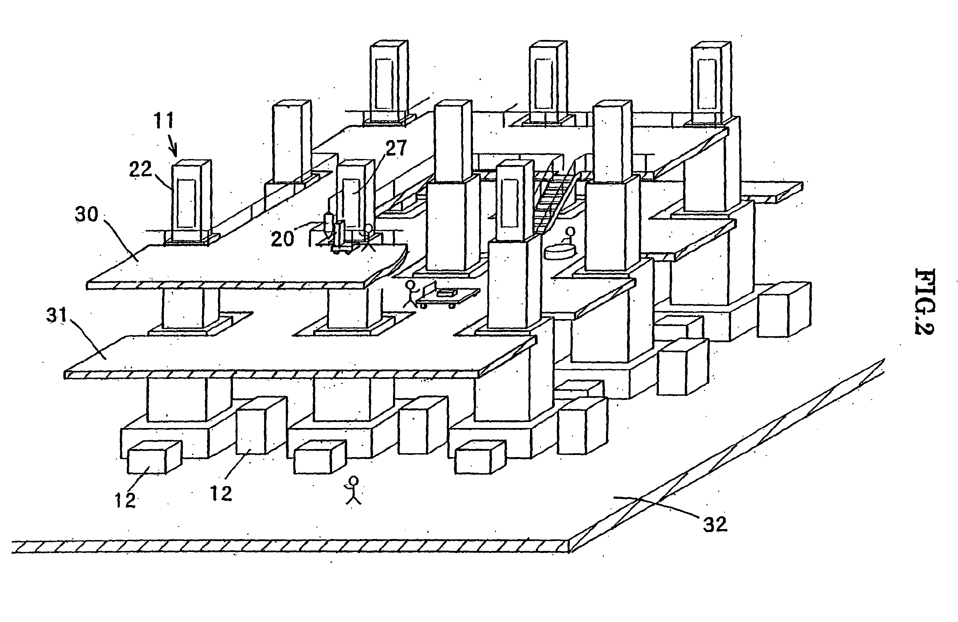

Fig. 1 is a schematic view showing an example of the pulling room of the present invention. Fig. 2 is a perspective view of the same.

For example, the pulling room shown in Fig. 1 is a pulling room provided with three-story operation floor, in which several to several tens of single crystal pulling apparatuses 11 are installed in the pulling room 1, and it is divided into three stories, an upper story, middle story and lower story, by an uppermost floor 30 and an intermediate floor 31. Further, there is provided a circulation type air conditioning system 2, in which clean air is blown off from a blow-off outlet 10 of filter 8 disposed near the ceiling of the upper story and contaminated flow is evacuated from a return duct 4 disposed on a side wall of the lower story or the like through the ventilation holes 6 provided on the uppermost floor 30 and the intermediate floor 31, thermally controlled by a heat exchanger 9, and sent out to a ventilation duct 3 by a ventilation fan 7.

Furthermore, on the lowermost floor 32, there are provided, besides the bodies of the pulling apparatuses 11, accessory apparatuses for operating the pulling apparatuses (electric power units, vacuum pumps, control panels, oil pressure apparatuses etc.), utility facilities 12 including piping for circulating cooling water, piping for waste gas, power cables and so forth. Extraordinarily clean environment is not required for this floor.

Hereafter, various operations performed for production for single crystals in the pulling room 1 will be explained.

First, on the uppermost floor 30 which requires the highest degree of cleanness, taking out of a completed single crystal ingot 20 through a door 27 for taking out a single crystal ingot of a pulling chamber 22 of the pulling apparatus 11 and unloading operation for subsequent steps are performed. Thus, the taking out and the unloading operation of a single crystal ingot, which is recently getting heavier weight, can be performed on the uppermost floor 30, and therefore these operations can be easily performed without a step or the like as in a conventional operation. Accordingly, these operations are not operations at a high position, and hence safety is also secured.

Further, on the uppermost floor, loading of the raw material polycrystal silicon 23, quartz crucible 24 and so forth, which hate dusts, is performed for the subsequent production of a single crystal.

Since the uppermost floor 30 is separated from the intermediate floor 31 for performing the cleaning operation and so forth, it is always maintained at high degree of cleanness and is suitable for loading the raw material and so forth. In particular, even if the charging of the raw material, dismantlement and cleaning are simultaneously performed in each of a plurality of pulling apparatuses 11, these operations are performed on the separate floors and therefore they do not influence on one another at all.

In addition, in order to set the raw material located on the uppermost floor 30 into the pulling apparatus 11, the raw material 23 and a dopant can be supplied into the quartz crucible 24, then a lid can be placed on it, inside of the crucible can be made vacuum, and the crucible can be hanged by a crane and set into the pulling apparatus by, for example, the method described in Japanese Patent Publication (Kokoku) No. 6-102587.

As for the crane for hanging the quartz crucible 24, its arm is attached to the pulling apparatus body (not shown in the drawings), and it utilizes a method of reeling up a wire by a motor via the arm. Further, in order to set the quartz crucible 24 in the pulling apparatus, the upper part of the furnace body can be opened by lifting and turning the pull chamber 22 by means of a turning mechanism 33 so that the crucible and the raw material can be hung from above and set in the furnace. In addition, when the furnace is dismantled and cleaned, the main chamber 21 can also be lifted and revolved by a turning mechanism not shown in the drawings.

On the intermediate floor 31, dismantlement, cleaning and assembling of the furnace body and structural members in the furnace body of the pulling apparatus and so forth are performed. These operations are accompanied by quite dusting. However, since ventilation holes 6 are provided also on the intermediate floor 31 and a down flow of clean air is secured in the pulling room, it does not affect on the upper story. Thus, the transportation and charging operations for the raw material and the crucible, which require high degree of cleanness, and the operations of dismantlement and cleaning of the pulling apparatus accompanied by dusting can be completely separated from each other. In this case, it is more preferred that clean air can be supplied as a down flow from a position right above the place where the dismantlement operation is performed so that dusts should not remain so much in the pulling apparatus after the dismantlement and cleaning operation.

On the lowermost floor 32, there are provided, besides the bodies of the pulling apparatuses 11, accessory apparatuses for operating the pulling apparatuses (electric power units, vacuum pumps, control panels, oil pressure apparatuses etc.), utility facilities 12 including piping for circulating cooling water, piping for waste gas, power cables and so forth, and everyday check of short circuit, leakage of water etc., maintenance, cleaning and so forth are performed. However, since these instruments and facilities do not require extraordinarily clean environment, sufficient operation effect can be obtained even with the degree of cleanness of the down flow that has passed through the intermediate floor 31.

If operation floors maintaining degrees of cleanness suitable for each operation are provided as described above, although the degree of cleanness of the uppermost floor, on which the raw material is loaded, set at, for example, class 1,000, is degraded to about class 10,000 when the dismantlement and cleaning operations of inside of the furnace body is performed, it does not affect the uppermost floor at all. Thus, high degree of cleanness is maintained, and it becomes possible to safely perform the operations requiring high degree of cleanness such as loading of the raw material without any problem.

The present invention is not limited to the embodiments described above. The above-described embodiments are mere examples, and any of those having the substantially same configuration as that described in the appended claims and providing similar functions and advantages are included in the scope of the present invention.

For example, in the embodiments described above, the present invention was explained by exemplifying a pulling room provided with three floors. However, the present invention is not limited to it, and four floors or five or more floors can also be provided in order to more finely subdividing the degree of cleanness depending on the purpose. In particular, the required crystal diameter will become larger, the heights of the pulling apparatus and pulling room will become higher and thus the need of four or more floors will become higher in future. Although the degree of cleanness was explained to be set at class 1,000 on the uppermost story, it can of course be set at class 100 or class 10, for example.

Further, the pulling apparatus used in the present invention may be not only a room for performing the usual Czochralski method, but also one for performing the MCZ method (Magnetic field applied Czochralski method), in which a magnetic field is applied at the time of pulling of a silicon single crystal.

## Claims

1. A cleaned pulling room installed with a plurality of single crystal pulling apparatuses, having a plurality of operation floors and supplied with clean air as a down flow from a ceiling or an upper position neighboring the ceiling, wherein at least three operation floors are provided depending on degrees of cleanness required for operations performed on each of the floors.

2. The pulling room according to Claim 1, wherein floor structure of the pulling room comprises at least an operation floor for loading of raw material and unloading of single crystals that require high degree of cleanness, which is provided in an uppermost story, an operation floor of low degree of cleanness for cleaning of inside of pulling apparatuses accompanied by dusting after production of single crystals and assembling of furnace body constituting members, which is provided in an intermediate story, and an operation floor on which pulling apparatus bodies, incidental facilities thereof and utility facilities not requiring cleanness are installed and maintenance operations therefor are performed, which is provided in a lowermost story.
